(19) Europäisches Patentamt
European Patent Office
Office européen des brevets

(11) **EP 4 394 367 A1**

(12) **EUROPEAN PATENT APPLICATION**
published in accordance with Art. 153(4) EPC

(43) Date of publication:
**03.07.2024 Bulletin 2024/27**

(21) Application number: **22917655.7**

(22) Date of filing: **25.11.2022**

(51) International Patent Classification (IPC):
**G01N 24/10** (2006.01)

(52) Cooperative Patent Classification (CPC):
**G01N 24/10**

(86) International application number:
**PCT/JP2022/043495**

(87) International publication number:
**WO 2023/132149 (13.07.2023 Gazette 2023/28)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **06.01.2022   JP 2022001004**

(71) Applicant: **University of Tsukuba
Ibaraki 305-8577 (JP)**

(72) Inventor: **MARUMOTO, Kazuhiro
Tsukuba-shi, Ibaraki 305-8577 (JP)**

(74) Representative: **E. Blum & Co. AG
Franklinturm
Hofwiesenstrasse 349
8050 Zürich (CH)**

(54) **ELECTRON SPIN RESONANCE DEVICE AND DETERIORATION EVALUATION METHOD**

(57)     An electron spin resonance device includes a microwave oscillator, a magnet, a modulation coil, and a cavity resonator having an opening. A microwave generated in the microwave oscillator resonates in the cavity resonator and is emitted from the opening toward a measurement target located outside the opening. The magnet applies a magnetic field toward an irradiation surface of the measurement target, the irradiation surface being irradiated with the microwave. The modulation coil modulates an intensity of the magnetic field or a frequency of the microwave applied toward the irradiation surface of the measurement target irradiated with the microwave.

FIG. 1

EP 4 394 367 A1

**Description**

Technical Field

The present invention relates to an electron spin resonance device and a deterioration evaluation method. The present application claims priority based on Japanese Patent Application No. 2022-001004 filed in Japan on January 6, 2022, the contents of which are incorporated herein by reference.

Background Art

An electron spin resonance (ESR) device is a device that can selectively measure free radicals. An electron spin resonance (ESR) device is used in basic physical science and pharmaceutical fields, production lines for semiconductors and the like, and medical fields such as for cancer diagnosis.

For example, Patent Document 1 describes an electron spin resonance device that applies a static magnetic field to a cavity resonator having a cylindrical cavity by using a pair of left and right magnetic field gradient coils and applies a high-frequency microwave inside the cavity resonator.

For example, Patent Document 2 discloses an electron spin resonance device that sweeps the frequency of a microwave while applying a constant magnetic field with a permanent magnet.

Citation List

Patent Document

Patent Document 1: JP 5481651 B
Patent Document 2: JP 2015-49072 A

Summary of Invention

Technical Problem

The electron spin resonance device described in Patent Document 1 applies a magnetic field to a specimen by using magnetic field gradient coils arranged sandwiching the specimen. This is to increase the Q value (quality factor) of the electron spin resonance device by applying a sufficient magnetic field to the specimen. The specimen needs to be inserted into the space between the magnetic field gradient coils, which limits the size and shape of the specimen. In addition, the device described in Patent Document 1 is large and is not portable.

Patent Document 2 states that a compact electron spin resonance device can be achieved by using a permanent magnet and a spiral-shaped inductor. On the other hand, in the device described in Patent Document 2, it is necessary to arrange the measurement target at a position surrounded by the spiral-shaped inductor, and thus the size and shape of the specimen that can be used are limited. Furthermore, Patent Document 2 does not state that the electron spin resonance device itself is carried and that measurement is performed at the new destination.

The present disclosure has been made in view of the above problems, and an object of the present disclosure is to provide an electron spin resonance device capable of measuring a measurement target having any shape and a deterioration evaluation method.

Solution to Problem

To solve the above problems, the present disclosure provides the following.

(1) An electron spin resonance device according to a first aspect includes a microwave oscillator, a magnet, a modulation coil, and a cavity resonator having an opening. The microwave generated by the microwave oscillator resonates in the cavity resonator and is irradiated from the opening toward a measurement target located outside the opening. The magnet applies a magnetic field toward an irradiation surface of the measurement target, the irradiation surface being irradiated with the microwave. The modulation coil modulates an intensity of the magnetic field or a frequency of the microwave applied toward the irradiation surface of the measurement target.

(2) The electron spin resonance device according to the aspect described above may be used for the measurement

target including $10^{11}$ spins/g or more in a permeation region which is irradiated and permeated by the microwave.

(3) In the electron spin resonance device according to the aspect described above, the measurement target may be a carbon fiber composite material.

(4) In the electron spin resonance device according to the aspect described above, the modulation coil may sweep the magnetic field in a range of ± 2 mT with 319.5 mT as a reference.

(5) The electron spin resonance device according to the aspect described above may be portable and may be installable with respect to a measurement target having any shape.

(6) The electron spin resonance device according to the aspect described above may include a plurality of units. Each of the plurality of units includes the microwave oscillator, the magnet, the modulation coil, and the cavity resonator.

(7) In the plurality of units of the electron spin resonance device according to the aspect described above, some of the units may share at least one of the microwave oscillator, the magnet, or the modulation coil.

(8) A deterioration evaluation method according to a second aspect includes: a detection step of irradiating a measurement target with a microwave, applying a magnetic field to an irradiation surface of the measurement target, the irradiation surface being irradiated with the microwave, and detecting a number of spins in the measurement target by electron spin resonance; and an evaluation step of evaluating deterioration of the measurement target from the number of spins.

(9) The deterioration evaluation method according to the aspect described above may further include, before the detection step, a preparation step of finding, in advance, a relationship between deterioration of a reference specimen and a number of spins in the reference specimen by using the reference specimen having the same configuration as the measurement target.

(10) In the deterioration evaluation method according to the aspect described above, the preparation step may include a step of finding a critical value by dividing a number of spins in the reference specimen at a time point when a load at which breakage of the reference specimen occurs is applied by a number of spins in the reference specimen before the load is applied; and the evaluation step may include a step of fitting a graph using the following Equation (1), the graph having a horizontal axis representing a number of applications (N) of the load to the measurement target, and a vertical axis representing a standardized number of spins ($N_{spin}(N)/N_{spin}(0)$) in the measurement target, and a step of substituting the critical value to a left side of the following Equation (1) and estimating the number of applications of the load at which breakage of the measurement target occurs.

$$N_{spin}(N)/N_{spin}(0) = A \log_{10} (N + 1) + 1 ...(1)$$

In Equation (1), $N_{spin}(N)$ is a number of spins in the measurement target after the load is applied N times, and $N_{spin}(0)$ is the number of spins in the measurement target before load application, and A is a constant.

(11) In the deterioration evaluation method according to the aspect described above, the preparation step may include a step of fitting a graph using the following Equation (2), the graph having a horizontal axis representing the number of applications (N) of the load to the reference specimen and a vertical axis representing the standardized number of spins ($N'_{spin}(N)/N'_{spin}(0)$) in the reference specimen.

$$N'_{spin}(N)/N'_{spin}(0) = A' \log_{10} (N + 1) + 1 ... (2)$$

In Equation (2), $N'_{spin}(N)$ is the number of spins in the reference specimen after the load is applied N times, $N'_{spin}(0)$ is the number of spins in the reference specimen before the load is applied, and A' is a constant.

(12) In the deterioration evaluation method according to the aspect described above, the evaluation step may include an estimation step of substituting the number of spins detected in the detection step into $N'_{spin}(N)$ in Equation (2) and estimating the number of times the load is applied to the measurement target.

(13) The deterioration evaluation method according to the aspect described above, the preparation step may include a step of finding the number of applications of the load at which breakage of the reference specimen occurs, and the evaluation step may include a step of finding a remaining service life of the measurement target by subtracting the number of times the load is applied to the measurement target estimated in the estimation step from the number of applications of the load at which damage of the reference specimen.

(14) In the deterioration evaluation method according to the aspect described above, the measurement target may be a carbon fiber composite material.

Advantageous Effects of Invention

The electron spin resonance device according to the above aspects is portable, and can measure a measurement target having any shape. The deterioration evaluation method according to the above aspect can evaluate deterioration of the measurement target using electron spin resonance.

Brief Description of Drawings

FIG. 1 is a schematic cross-sectional view of an electron spin resonance device according to a first embodiment.
FIG. 2 is a conceptual diagram showing a measurement principle of the electron spin resonance device according to the first embodiment.
FIG. 3 is a first flowchart of a deterioration evaluation method according to the first embodiment.
FIG. 4 is a second flowchart of the deterioration evaluation method according to the first embodiment.
FIG. 5 is a schematic perspective view of an electron spin resonance device according to a first modification.
FIG. 6 is a schematic perspective view of an electron spin resonance device according to a second modification.
FIG. 7 is a conceptual diagram of a measurement sample of a first experimental example.
FIG. 8 is a measurement result of the first experimental example.
FIG. 9 is a graph of original data of an ESR signal found in a second experimental example.
FIG. 10 is a graph obtained by integrating the original data of the ESR signal found in the second experimental example once.
FIG. 11 is a graph showing the dependency of the number of spins on the number of loads applications in the second experimental example.
FIG. 12 is a graph showing the dependency of the ESR full width at half maximum on the number of load applications in the second experimental example.
FIG. 13 is a graph showing the dependency of the number of spins on the number of loads applications in the third experimental example.
FIG. 14 is a result of fitting a graph showing the dependency of the number of spins on the number of loads applications.

Description of Embodiments

Hereinafter, the present embodiment will be described in detail with reference to the drawings as appropriate. In the drawings referenced in the following description, characteristic portions may be illustrated in an enlarged manner for convenience to facilitate understanding of the features of the present invention, and dimensional ratios and the like of the respective components may be different from reality. The materials, dimensions, and the like provided in the following description are exemplary examples. The present invention is not limited thereto, and the present invention can be appropriately changed and implemented within a range in which the gist of the invention is not changed.

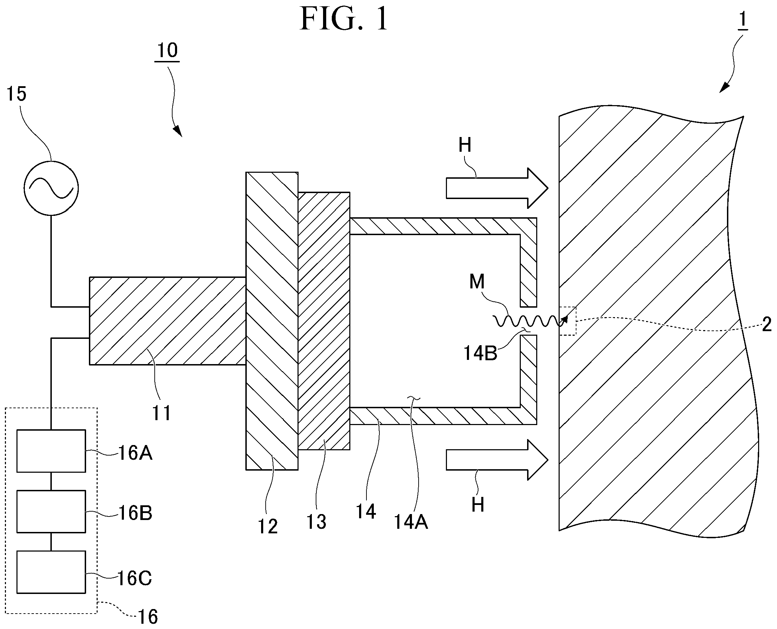

FIG. 1 is a schematic cross-sectional view of an electron spin resonance device 10 according to a first embodiment. The electron spin resonance device 10 is used for evaluating the state of a measurement target 1.

The electron spin resonance device 10 includes, for example, a microwave oscillator 11, a magnet 12, a modulation coil 13, and a cavity resonator 14. The electron spin resonance device 10 is connected to a power supply 15 and a detection device 16 at the time of use.

The microwave oscillator 11 generates a microwave M when connected to the power supply 15. The power supply 15 is, for example, a high-frequency power supply. As the microwave oscillator 11, a known microwave oscillator can be used as long as it generates microwaves. The frequency of the microwave M is not particularly limited. For example, the frequency of the microwave M is 9 GHz.

The cavity resonator 14 is located at a position where the microwave M generated by the microwave oscillator 11 reaches. The microwave M generated by the microwave oscillator 11 reaches the cavity resonator 14. A cavity 14A is located inside the cavity resonator 14. An opening 14B is located at a part of the cavity resonator 14. The microwave M resonates in the cavity 14A and is emitted from the opening 14B to the outside. At least a part of the measurement target 1 is irradiated with the microwave M emitted from the opening 14B. Hereinafter, a surface of the measurement target 1 irradiated by the microwave M is referred to as an irradiation surface. The measurement target 1 is located at a position facing the opening 14B. The opening 14B has, for example, a circular shape having a diameter of 3 cm.

The magnet 12 applies a magnetic field H toward the measurement target 1. The magnet 12 applies a magnetic field H toward the irradiation surface of the measurement target 1 to be irradiated with the microwave M. The magnet 12 is disposed, for example, at a position facing the measurement target 1. The magnet 12 is, for example, a permanent magnet.

The modulation coil 13 changes the strength (magnetic flux density) of the magnetic field H applied from the magnet 12 to the irradiation surface of the measurement target 1, for example. The modulation coil 13 may change the frequency of the microwave M. The modulation coil 13 includes, a first modulation coil that determines a reference for the magnetic field to be applied and a second modulation coil that sweeps the strength of the magnetic field in a certain range from the reference magnetic field intensity.

For example, the first modulation coil sets the strength of the magnetic field H to be applied from the magnet 12 to the measurement target 1 to a resonance magnetic field $H_0$. When the measurement target 1 is a carbon fiber composite material, for example, the resonance magnetic field $H_0$ is 319.5 mT. For example, the second modulation coil sweeps the magnetic field in a certain range with reference to the resonance magnetic field $H_0$. In a case where the measurement target 1 is determined, it is not necessary to widen the sweep width of the magnetic field. For example, the second modulation coil sweeps in a range of $\pm$ 2 mT with reference to the resonance magnetic field $H_0$. The sweep width may be in a range of $\pm$ 1 mT with reference to the resonance magnetic field $H_0$. In a case where the measurement target 1 is determined, the sweep width may be narrow. In other words, the modulation coil 13 does not need to sweep the magnetic field with a wide width, and thus can be made smaller.

The detection device 16 includes a detector 16A, an amplifier 16B, and a calculator 16C. The detector 16A detects an electron spin resonance (ESR) signal. The detector 16A is, for example, a crystal diode detector. The amplifier 16B amplifies an electron spin resonance signal. The calculator 16C is, for example, a computer. The calculator 16C is used to analyze the electron spin resonance signal. The calculator 16C has, for example, a recording area in which the detected data is recorded and a signal processing area in which the detected data is analyzed.

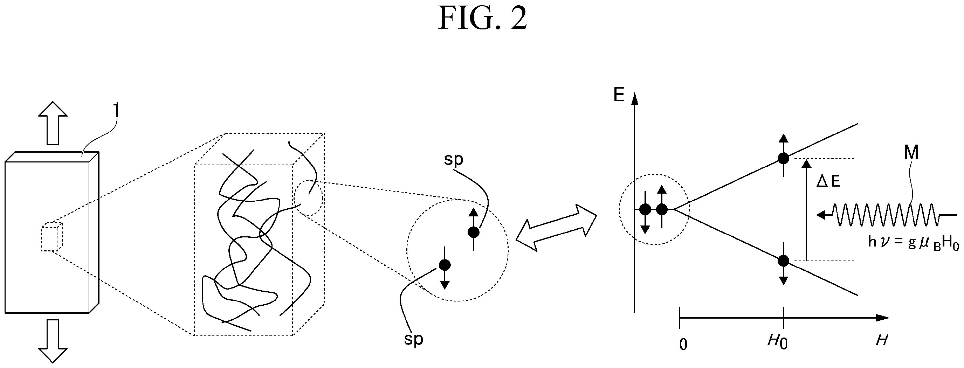

FIG. 2 is a conceptual diagram showing the measurement principle of the electron spin resonance device 10 according to the first embodiment.

As illustrated in FIG. 2, when a load is applied to the measurement target 1, the state of the measurement target 1 changes. When a load is applied to the measurement target 1, for example, intermolecular force between polymer chains changes, polymer chains are cut, cross-linked structures are broken, or stress applied to the inter-fiber interface bond changes. When a polymer chain is cut, for example, a radical is generated at the cut surface and thus a spin sp (unpaired electron) is generated in the measurement target 1.

The spin sp is split into a $\beta$ spin parallel to the magnetic field and an $\alpha$ spin antiparallel to the magnetic field due to the Zeeman effect in the magnetic field. The energy difference between the $\alpha$ spin and the $\beta$ spin increases in proportion to the magnetic field intensity. When the energy difference $\Delta E$ matches the energy of the microwave M ($h\nu = g\mu_B H_0$), the electron spin absorbs the microwave M and transitions to the upper state. The electron spin resonance signal is observed at the time of this transition in state. The electron spin resonance signal is, for example, an absorption spectrum of the microwave M. The electron spin resonance device 10 evaluates the state of the measurement target 1 by this procedure.

The measurement principle of the electron spin resonance device 10 has been described using case where the microwave M is fixed and the magnetic field intensity is swept by way of example, but the magnetic field intensity may be fixed and the frequency of the microwave M may be swept.

The measurement target 1 may have a high concentration spin. For example, the measurement target 1 includes $10^{11}$ spins/g or more in a permeation region 2 in which the microwave M is irradiated and which the microwave permeates. The measurement target 1 preferably includes $10^{15}$ spins/g or more, more preferably includes $10^{17}$ spins/g or more, and further preferably includes $10^{20}$ spins/g or more in the permeation region 2. If the measurement target 1 is limited to a substance having a high concentration spin, the electron spin resonance device 10 is not required to have high sensitivity. Thus, the electron spin resonance device 10 according to the present embodiment can be reduced in size and simplified in configuration.

The permeation region 2 is a range in which the microwave M can permeate. The permeation region 2 is represented by the product of "an area irradiated with the microwave M" and "a permeation depth of the microwave M". In the measurement target 1, the region irradiated with the microwave M is a region facing the opening 14B. Thus, for example, the area of the measurement target 1 irradiated with the microwave M substantially matches the area of the opening 14B. The area irradiated with the microwave M matches the area of the irradiation surface. The permeation depth of the microwave M in the measurement target 1 is, for example, about 1cm. That is, the permeation region 2 is, for example, a region of about 10 cm$^3$.

The measurement target 1 is, for example, a carbon fiber composite material. The carbon fiber composite material is, for example, carbon fiber reinforced plastic (CFRP) or carbon fiber reinforced thermoplastic (CFRTP). CFRP is a reinforced plastic in which carbon fibers are used as a reinforcing material and a thermosetting resin is used as a base material. CFRTP is a reinforced plastic in which carbon fibers are used as a reinforcing material and a thermoplastic resin is used as a base material. In the carbon fiber composite material, internal stress is likely to occur at the time of manufacturing due to a difference in thermal shrinkage between the carbon fibers and the resin. Therefore, the carbon fiber composite material has a high concentration spin even in a no-load state before applying a load. Carbon fiber composite materials are used in airplanes, automobiles, and the like.

The electron spin resonance device 10 is small, lightweight, and portable. Additionally, since the electron spin resonance device 10 applies the magnetic field H and the microwave M in the same direction, the measurement target 1 does not need to be sandwiched by generation sources of the magnetic field H and the microwave M. Accordingly, the size and shape of the measurement target 1 are not limited and a measurement target 1 having any shape can be measured. For example, even when the measurement target 1 is an airplane or the like, the state of the measurement target 1 can be evaluated by orienting the opening 14B of the electron spin resonance device 10 toward the measuring location.

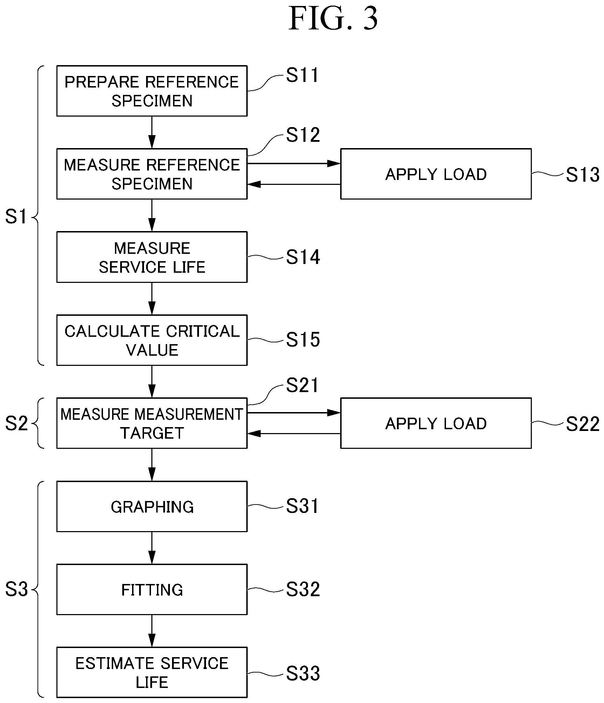

Next, a method for evaluating deterioration of a measurement target using the electron spin resonance device 10 according to the present embodiment will be described. FIG. 3 is a first flowchart of the deterioration evaluation method according to the first embodiment.

The deterioration evaluation method includes a preparation step S1, a detection step S2, and an evaluation step S3. The preparation step S1 is performed in advance before evaluating the actual measurement target 1. The actual measurement target 1 is measured in the detection step S2 and the evaluation step S3.

The preparation step S1 includes a reference specimen preparation step S11, a reference specimen measurement step S12, a load application step S13, a service life measurement step S14, and a critical value calculation step S15. The preparation step S1 is performed before the detection step S2. In the preparation step S 1, a reference specimen having the same configuration as the measurement target 1 is used to find, in advance, the relationship between the deterioration of the reference specimen and the electron spin resonance signal (ESR signal) of the reference specimen.

In the reference specimen preparation step S11, the reference specimen is prepared. The reference specimen is made of a substance similar to that of the measurement target 1. For example, the reference specimen is a specimen produced under the same conditions as the measurement target 1. The reference specimen is, for example, a carbon fiber composite material. The size of the reference specimen does not need to be the same as that of the measurement target 1, and may be any size.

In the reference specimen measurement step S12, an electron spin resonance analysis is performed on the reference specimen. The reference specimen measurement step S 12 is performed before applying a load to the reference specimen and is performed each time the load is applied a predetermined number of times. The reference specimen measurement step S12 may be performed using, for example, the above-described electron spin resonance device 10 or a known electron spin resonance device. Since the size of the reference specimen is not limited, the measurement can be performed using a known electron spin resonance device, in which a specimen is put into a cavity in which microwaves resonate.

In the load application step S 13, a load is applied to the reference specimen. For example, the reference specimen is stretched in one direction. With a cycle of applying a load to the reference specimen and releasing the load as one time, the load is applied to the reference specimen a plurality of times. The reference specimen measurement step S12 is performed every certain number of load applications.

In the service life measurement step S 14, the number of load applications at which the reference specimen becomes damaged is found. Examples of damage of the reference specimen include delamination and complete breakage. Delamination is the formation of cracks extending in a plane inside the reference specimen, and complete breakage means that the reference specimen is completely fractured. In the service life measurement step S14, for example, the number of load applications at which delamination occurs and the number of load applications at which complete breakage occurs are found.

In the critical value calculation step S 15, at least one of the standardized number of spins at the time when delamination occurs and the standardized number of spins at the time when complete breakage occurs is found. Assume that the number of load applications until breakage is represented by $N_{max}$, and the number of spins in the reference specimen at that time is represented by $N'_{spin} (N_{max})$. The value obtained by dividing $N'_{spin} (N_{max})$ by $N'_{spin} (0)$ is the standardized number of spins at the time when breakage occurs, and is hereinafter referred to as a critical value. $N'_{spin} (0)$ is the number of spins in the reference specimen before load application. The critical value represents how many times the number of spins increased from the initial state in which the load is applied until the breakage occurs. As an example, delamination may occur when the critical value is 1.85 (the number of spins is 1.85 times), and complete breakage may occur when the critical value is about 2.0 times (the number of spins is about 2 times).

In the detection step S2, the actual measurement target 1 is measured. The detection step S2 includes an actual measurement step S21 of actually measuring the measurement target 1 and a load application step S22 of applying a load to the measurement target 1.

The actual measurement step S21 may be performed before applying the load to the measurement target 1 and each time the load is applied a predetermined number of times. The actual measurement step S21 is performed using, for example, the electron spin resonance device 10 described above. In the actual measurement step S21, the microwave M and the magnetic field H are applied to the measurement target 1, and the electron spin resonance signal of the measurement target 1 is detected by electron spin resonance.

In the actual measurement step S21, the intensity of the magnetic field H may be fixed and the frequency of the microwave M may be swept, or the frequency of the microwave M may be fixed and the intensity of the magnetic field H may be swept. Here, a case where the frequency of the microwave M is fixed and the intensity of the magnetic field H is swept will be described as an example.

First, the electron spin resonance device 10 is set with the opening 14B of the electron spin resonance device 10 facing the measurement target 1. Since the electron spin resonance device 10 is small and portable, the electron spin resonance device 10 can also be set for a large measurement target 1 such as an airplane or an automobile, for example.

Next, the microwave oscillator 11 is connected to the power supply 15 to generate a microwave. The microwave M generated by the microwave oscillator 11 resonates in the cavity 14A and is emitted to the measurement target 1 from the opening 14B.

Next, in this state, the intensity of the magnetic field H generated from the magnet 12 is swept using the modulation coil 13. When the energy difference $\Delta E$ between the $\alpha$ spin and the $\beta$ spin generated by the magnetic field H matches the energy of the microwave M, the microwave M is absorbed. Since the intensity of the magnetic field H at which the microwave M is absorbed can be confirmed by preliminary examination, the sweep width of the intensity of the magnetic field H may be narrow. For example, in a case where the measurement target 1 is a carbon fiber composite material, the microwave M is absorbed at 319.5 mT, and thus the magnetic field is swept in a range of $\pm$ 2 mT with 319.5 mT as a reference.

The microwave M is reflected by the measurement target 1 and detected by the detector 16A of the detection device 16. At the magnetic field intensity at a predetermined time, the microwave M is absorbed by the measurement target 1, and thus an absorption spectrum of the microwave M is obtained.

In the load application step S22, a load is applied to the measurement target 1. With a cycle of applying a load to the measurement target 1 and releasing the load as one cycle, the load is applied to the measurement target 1 a plurality of times. The actual measurement step S21 is performed every certain number of load applications.

Next, in the evaluation step S3, the data detected in the detection step S2 is analyzed, and the deterioration of the measurement target 1 is evaluated from the detected number of spins in the measurement target 1. The evaluation step S3 is performed, for example, by the calculator 16C of the detection device 16. The evaluation step S3 includes a graphing step S31, a fitting step S32, and a service life estimation step S33.

First, the number of spins contained in the measurement target 1 is found each time the actual measurement step S21 is performed. The number of spins in the measurement target 1 can be found from the absolute value of an integrated intensity found by integrating the original signal detected by the electron spin resonance device 10 twice.

In the graphing step S31, a graph in which the horizontal axis represents the number of load applications to the measurement target 1 (N) and the vertical axis represents the standardized number of spins in the measurement target 1 ($N_{spin}(N)/N_{spin}(0)$) is produced. $N_{spin}(N)$ is the number of spins in the measurement target 1 after the load is applied N times, and $N_{spin}(0)$ is the number of spins in the measurement target 1 before the load is applied ($N_{spin}(0)$). Since the number of spins in the measurement target before the load is applied ($N_{spin}(0)$) depends on the material of the measurement target 1, the material dependency can be eliminating by normalization, and the state of the spin generated by load application can be extracted.

In the fitting step S32, the produced graph is fitted. The fitting is performed by the following Equation (1).

$$N_{spin}(N)/N_{spin}(0) = A\log_{10}(N + 1) + 1... (1)$$

In Equation (1), A is a constant.

In the service life estimation step S33, the critical value found in the critical value calculation step S15 is substituted into the left side of Equation (1). To determine the number of load applications at which delamination occurs, for example, 1.85 is substituted, and to determine the number of load applications at which complete breakage occurs, for example, 2.0 is substituted. Furthermore, the constant A is found from the fitting of the graph. Therefore, by substituting these values, the variable is only N and the number of applications N of a load that causes the measurement target 1 to break (delamination or complete breakage) can be estimated.

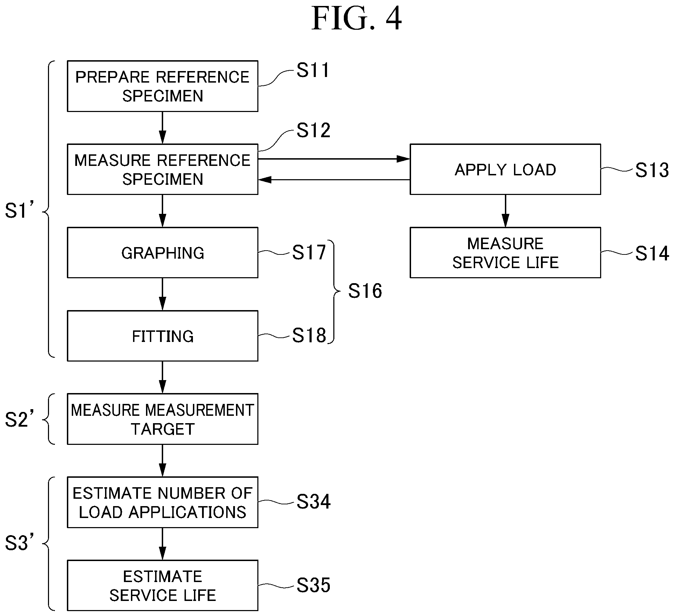

A first method for estimating the service life of the measurement target 1 has been described above, but the method for estimating the service life is not limited to this example. FIG. 4 is a second flowchart of the deterioration evaluation method according to the first embodiment.

The deterioration evaluation method based on the second flowchart includes a preparation step S1', a detection step S2', and an evaluation step S3'. The preparation step S1' is a preparation step performed in advance before the actual measurement target 1 is evaluated. The detection step S2' and the evaluation step S3' are actual measurement steps for measuring the actual measurement target 1.

The preparation step S1' includes a reference specimen preparation step S11, a reference specimen measurement step S12, a load application step S13, a service life measurement step S14, and an analyzing step S16. The reference specimen preparation step S11, the reference specimen measurement step S12, the load application step S13, and the service life measurement step S14 are the same as those in the first flow.

In the analyzing step S16, the relationship between the number of times the load is applied to the reference specimen and the electron spin resonance signal of the reference specimen measured in the reference specimen measurement step S12 is analyzed. The analyzing step S16 includes a graphing step S17 and a fitting step S18.

In the graphing step S17, a graph in which the horizontal axis represents the number of load applications to the reference specimen (N) and the vertical axis represents the standardized number of spins in the reference specimen $(N'_{spin}(N)/N'_{spin}(0))$ is produced. $N'_{spin}(N)$ is the number of spins in the reference specimen after the load is applied N times, and $N'_{spin}(0)$ is the number of spins in the reference specimen before the load is applied $(N_{spin}(0))$.

In the fitting step S18, the produced graph is fitted. The fitting is performed by the following Equation (2).

$$N'_{spin}(N)/N'_{spin}(0) = A' \log_{10}(N + 1) + 1 ...(2)$$

In Equation (2), A' is a constant. The graph produced in the graphing step S17 varies depending on a weight level S. The weight level S is obtained by dividing a maximum weight $P_{max}$ by a reference weight $P_t$ (initial damage confirmation weight). The constant A' for each weight level S is found by performing the fitting step S18.

In the detection step S2', the actual measurement target 1 is measured. The detection step S2' is performed using, for example, the electron spin resonance device 10 described above. In the detection step S2', the measurement target 1 is irradiated with the microwave M, the magnetic field H is applied to the irradiation surface of the measurement target irradiated with the microwaves M, and an electron spin resonance signal of the measurement target 1 is detected by electron spin resonance. The detection method in the detection step S2' is the same as that in the actual measurement step S21 described above.

Next, in the evaluation step S3', the data detected in the detection step S2' is analyzed, and the deterioration of the measurement target 1 is evaluated from the detected number of spins in the measurement target 1. The evaluation step S3' is performed, for example, by the calculator 16C of the detection device 16. The evaluation step S3' includes an estimation step S34 for the number of load applications and a service life estimation step S35.

First, the number of spins contained in the measurement target 1 is found. The number of spins in the measurement target 1 can be found from the absolute value of an integrated intensity found by integrating the original signal detected by the electron spin resonance device 10 twice.

Next, in the estimation step S34 for the number of load applications, the number of spins in the measurement target 1 is substituted into $N'_{spin}(N)$ of Equation (2). In addition, the number of spins in the measurement target 1 in the initial state (when new) measured in advance is substituted into $N'_{spin}(0)$ of Equation (2). The constant A' is found by finding the weight level S applied to the measurement target 1. The number of applications N of the load applied to the measurement target 1 is found by substituting the above values and calculating Equation (2). Through this procedure, the number of applications N of the load applied to the measurement target 1 can be estimated from the result of electron spin resonance.

As described above, in the service life measurement step S 14, the number of applications of a load at which damage of the reference specimen occurs is found. The relationship between the number of applications of the load and the number of spins in the reference specimen substantially matches the relationship between the number of applications of the load and the number of spins in the measurement target 1. Accordingly, the number of load applications at which delamination occurs found in the service life measurement step S 14 substantially matches the number of load applications at which delamination of the measurement target 1 occurs, and the number of load applications at which complete breakage occurs found in the service life measurement step S 14 substantially matches the number of load applications at which complete breakage of the measurement target 1 occurs.

Thus, in the service life estimation step S35, the remaining service life of the measurement target 1 can be estimated by subtracting the number of times the load is applied to the measurement target 1 estimated in the estimation step S34 from the number of applications of the load at which damage of the reference specimen found in the service life measurement step S14.

The method using the first flow is highly reliable since fitting is performed using actual measurement values. Since the method using the second flow requires only one measurement of the measurement target 1, this method is suitable for a measurement target having an unknown state.

As described above, since the electron spin resonance device 10 according to the present embodiment limits the measurement target 1, a high Q value is not required, and thus the size can be reduced and the configuration can be simplified. In addition, since the electron spin resonance device 10 according to the present embodiment applies the magnetic field H and the microwave M toward the measurement target 1 from one direction, measurement can be performed regardless of the shape or size of the measurement target 1.

In the deterioration evaluation method according to the present embodiment, deterioration of the carbon fiber composite material can be evaluated using electron spin resonance. In addition, the deterioration evaluation method according to the present embodiment can estimate the number of applications of a load and the remaining service life by performing preliminary examination using a reference sample.

An example of the electron spin resonance device 10 and the deterioration evaluation method have been described so far. However, the present invention is not limited to this embodiment.

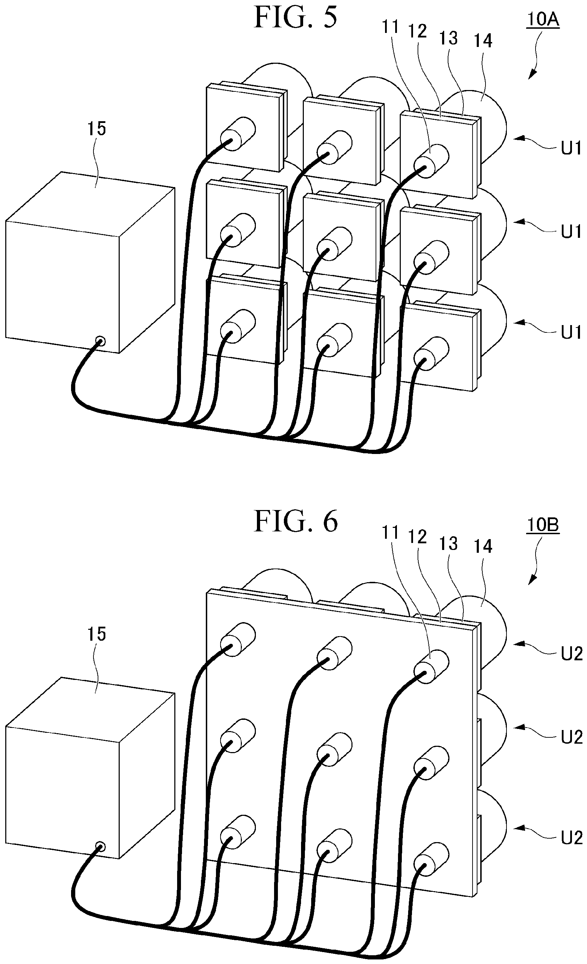

For example, FIG. 5 is a schematic perspective view of an electron spin resonance device 10A according to a first modification. The electron spin resonance device 10A includes a plurality of units U1.

Each of the plurality of units U1 includes a microwave oscillator 11, a magnet 12, a modulation coil 13, and a cavity resonator 14. The microwave oscillator 11, the magnet 12, the modulation coil 13, and the cavity resonator 14 are the same as those described above.

The arrangement of the plurality of units U1 is not particularly limited. The plurality of units U1 are arranged in, for example, a line or an array. The plurality of units U1 are connected to, for example, one power supply 15. A high frequency wave generated by the power supply 15 is branched by wiring and propagated to each microwave oscillator 11.

Since the electron spin resonance device 10A according to the first modification includes the plurality of units U1, measurement of a large area can be performed at one time.

Furthermore, for example, FIG. 6 is a schematic perspective view of an electron spin resonance device 10B according to a second modification. The electron spin resonance device 10B includes a plurality of units U2.

Each of the plurality of units U2 includes a microwave oscillator 11, a magnet 12, a modulation coil 13, and a cavity resonator 14. The microwave oscillator 11, the magnet 12, the modulation coil 13, and the cavity resonator 14 are the same as those described above. Some of the units U2 of the plurality of units U2 share at least one of the microwave oscillator 11, the magnet 12, or the modulation coil 13 with other units U2. FIG. 6 illustrates an example in which the magnet 12 is shared by the plurality of units U2. In this case, the magnets 12 of the adjacent units U2 are integrated.

Since the electron spin resonance device 10B according to the first modification includes the plurality of units U2, measurement of a large area can be performed at one time. In addition, handling is easy because the units U2 are connected to each other.

Examples

First Experimental Example

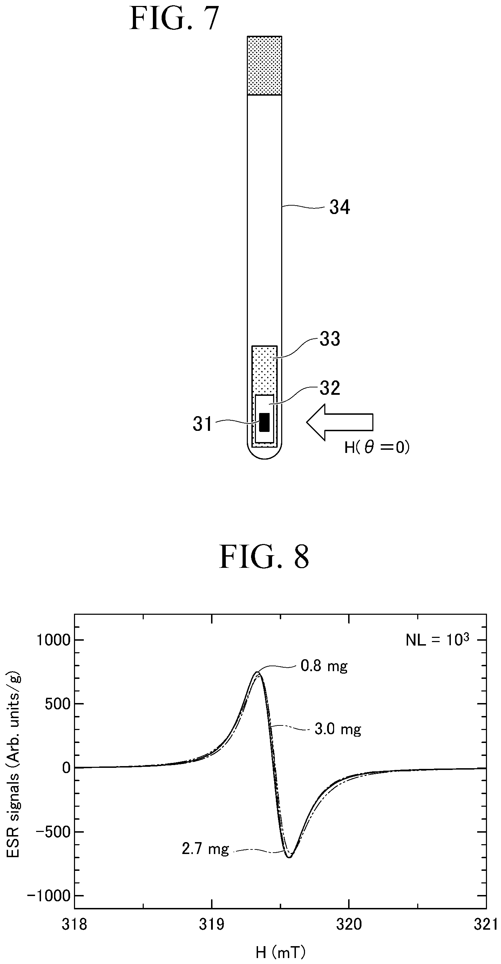

FIG. 7 is a conceptual diagram of a measurement sample of a first experimental example. In the first experimental example, a carbon fiber composite material 31 having a predetermined size was affixed to a polyethylene terephthalate (PET) substrate 33 with a double-sided tape 32, and these components were sealed in a sample tube 34 in the atmosphere.

T700S [0/90_4/0] (six layers) manufactured by Toray Industries, Inc. was used as the carbon fiber composite material 31. The carbon fiber composite material 31 was a CFRP. For the carbon fiber composite material 31, a specimen of 10 mm $\times$ 150 mm $\times$ 1. 2 mm was used, and a load was applied $10^3$ times. The load conditions were 950 N, 2 Hz and R0.1 sine waves.

As measurement specimens, a sample 1 cut out in a size of 2 mm $\times$ 1 mm (3.0 mg), a sample 2 cut out in a size of 2 mm $\times$ 0.9 mm (2.7 mg), and a sample 3 cut out in a size of 2 mm $\times$ 0.27 mm (0.8 mg) were prepared.

Then, the magnetic field H was applied from a direction orthogonal to the side surface of the sample tube 34 to perform electron spin resonance. The measurement was carried out at room temperature.

FIG. 8 shows the measurement results of the first experimental example. A difference was barely observed in the intensity of the ESR signal, the g-factor, and the ESR line width of sample 1, sample 2, and sample 3. The carbon fiber composite material shows that the number of spins contained in the initial state is sufficiently larger than the number of spins generated at the cut surface by cutting or the like. That is, evaluation can be performed regardless of the processing size, and evaluation of the measurement target 1 can be performed based on the reference specimen.

Second Experimental Example

In a second experimental example, the same carbon fiber composite material as in the first experimental example was used to evaluate the dependency of the electron spin resonance signal on the number of times the load is applied to the carbon fiber composite material.

With the load conditions applied to the specimen set the same as in the first example, specimens were prepared for the number of load applications of 0 times, $10^3$ times, $10^4$ times, $10^5$ times, and $10^6$ times.

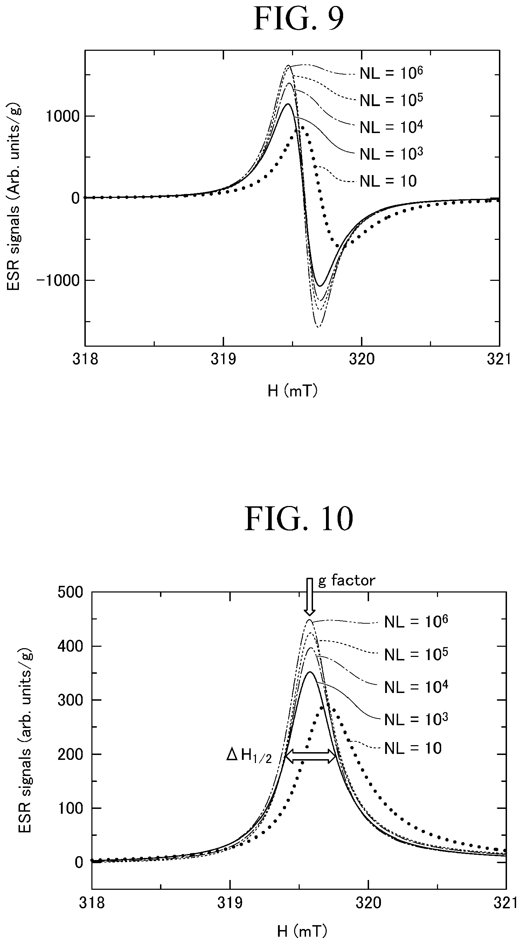

FIG. 9 is a graph of the original data of the electron spin resonance signal found in the second experimental example, and FIG. 10 is a graph obtained by integrating the original data once. As shown in FIGS. 9 and 10, the spectrum clearly changed depending on the number of load applications. For example, the ESR signal intensity at the g-factor corresponding to the apex of the one-time integration graph (FIG. 10) increased as the number of load applications increased. Furthermore, the ESR full width at half maximum, which is the half width of the one-time integration graph (FIG. 10), became narrower as the number of load applications increased.

In a region where the number of load applications was $10^6$ times or less, the rigidity of the specimen did not significantly reduce, and no visible transverse cracking was found. In other words, the deterioration of the material could be detected even in a state where a weak load causing no apparent deterioration was applied.

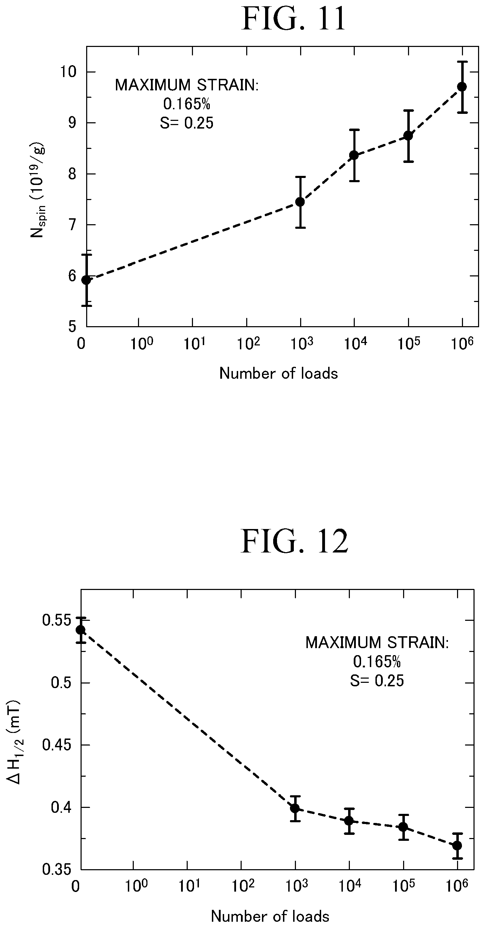

FIG. 11 is a graph showing the dependency of the number of spins on the number of load applications found in the second experimental example. As shown in FIG. 11, the spin concentration per unit mass of the carbon fiber composite material monotonically increased as the number of load applications increased, and logarithmic dependency was confirmed with respect to the number of load applications. This is thought to be because, breakage of molecular chains or breakage of cross-linked structures occurred due to fatigue deterioration of the carbon fiber composite material, thereby generating spins (radicals).

FIG. 12 is a graph showing the dependency of the ESR full width at half maximum on the number of load applications found in the second experimental example. The ESR full width at half maximum monotonically decreased as the number of load applications increased. The ESR full width at half maximum is a parameter proportional to inter-spin magnetic dipole interaction. A decrease in the ESR full width at half maximum means an increase in the average distance between spins. This result is thought to reflect a state where the carbon fiber composite material has deteriorated and the number of voids in the material has increased.

Third Experiment Example

In a third experimental example, a carbon fiber composite material (CFRP) using the same thermosetting resin as in the first experimental example and a carbon fiber composite material (CFRTP) using a thermoplastic resin were used to evaluate the dependency of the number of spins in the carbon fiber composite material on the load condition.

A first sample was prepared under the same conditions as in the second experimental example. The weight level S of the first sample was 0.25. A second sample was a carbon fiber composite material (CFRTP) with a thermoplastic resin and was added with twice the weight level of the second experimental example. The weight level S of the second sample was 0.5.

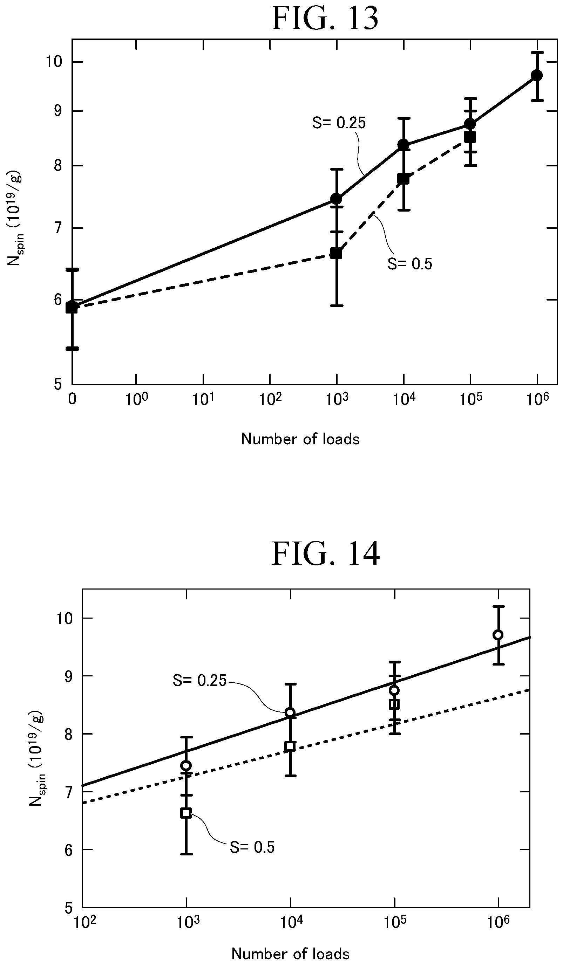

FIG. 13 is a graph showing the dependency of the number of spins on the number of load applications found in the third experimental example. The number of spins tended to increase logarithmically regardless of the difference in the weight level S or the carbon fiber composite material. FIG. 14 is a graph obtained by fitting the graph of FIG. 13 with $N_{spin} (N) = a\log_{10} (N + 1) + N_{spin} (0)$, and both graphs were fitted appropriately.

Reference Signs List

1 Measurement target
2 Permeation region
10, 10A, 10B Electron spin resonance device
11 Microwave oscillator
12 Magnet
13 Modulation coil
14 Cavity resonator
14A Cavity
14B Opening
15 Power source
16 Detection device
16A Detector
16B Amplifier
16C Calculator
31 Carbon fiber composite material
32 Double-sided tape
33 Substrate
34 Sample tube
S1, S1' Preparation step
S2, S2' Detection step

S3, S3' Evaluation step
S11 Reference specimen preparation step
S12 Reference specimen measurement step
S13, S22 Load application step
S14 Service life measurement step
S15 Critical value calculation step
S16 Analyzing step
517, S31 Graphing step
518, S32 Fitting step
S21 Actual measurement step
S33, S34, S35 Estimation step
U1, U2 Unit

**Claims**

1. An electron spin resonance device comprising a microwave oscillator, a magnet, a modulation coil, and a cavity resonator having an opening, wherein

   a microwave generated by the microwave oscillator resonates in the cavity resonator and is emitted from the opening toward a measurement target located outside the opening,
   the magnet applies a magnetic field toward an irradiation surface of the measurement target, the irradiation surface being irradiated with the microwave, and
   the modulation coil modulates an intensity of the magnetic field or a frequency of the microwave applied toward the irradiation surface of the measurement target.

2. The electron spin resonance device according to claim 1, wherein
   the electron spin resonance device is used for the measurement target including $10^{11}$ spins/g or more in a permeation region which is irradiated and permeated by the microwave.

3. The electron spin resonance device according to claim 1, wherein
   the measurement target is a carbon fiber composite material.

4. The electron spin resonance device according to claim 1, wherein
   the modulation coil sweeps the magnetic field in a range of $\pm$ 2 mT with 319.5 mT as a reference.

5. The electron spin resonance device according to claim 1, wherein
   the electron spin resonance device is portable and installable with respect to a measurement target having any shape.

6. The electron spin resonance device according to claim 1, further comprising a plurality of units, wherein
   each of the plurality of units includes the microwave oscillator, the magnet, the modulation coil, and the cavity resonator.

7. The electron spin resonance device according to claim 6, wherein
   some units of the plurality of units share at least one of the microwave oscillator, the magnet, or the modulation coil.

8. A deterioration evaluation method comprising:

   a detection step of irradiating a measurement target with a microwave, applying a magnetic field to an irradiation surface of the measurement target, the irradiation surface being irradiated with the microwave, and detecting an electron spin resonance signal of the measurement target by electron spin resonance; and
   an evaluation step of evaluating deterioration of the measurement target from the electron spin resonance signal.

9. The deterioration evaluation method according to claim 8, further comprising, before the detection step, a preparation step of finding, in advance, a relationship between deterioration of a reference specimen and an electron spin resonance signal of the reference specimen by using the reference specimen having the same configuration as the measurement target.

10. The deterioration evaluation method according to claim 9, wherein

the preparation step includes a step of finding a critical value by dividing a number of spins in the reference specimen at a time point when a load at which breakage of the reference specimen occurs is applied by a number of spins in the reference specimen before the load is applied, and
the evaluation step includes:

a step of fitting a graph using the following Equation (1), the graph having a horizontal axis representing a number of applications (N) of the load to the measurement target, and a vertical axis representing a standardized number of spins ($N_{spin}(N)/N_{spin}(0)$) in the measurement target, and
a step of substituting the critical value to a left side of the following Equation (1) and estimating a number of applications of the load at which breakage of the measurement target occurs,

$$N_{spin}(N)/N_{spin}(0) = A\log_{10}(N+1) + 1 \dots (1)$$

where, in Equation (1), $N_{spin}(N)$ is the number of spins in the measurement target after the load is applied N times, $N_{spin}(O)$ is the number of spins in the measurement target before the load is applied, and A is a constant.

11. The deterioration evaluation method according to claim 9, wherein

the preparation step includes a step of fitting a graph using the following Equation (2), the graph having a horizontal axis representing a number of applications (N) of the load to the reference specimen and a vertical axis representing a standardized number of spins ($N'_{spin}(N)/N'_{spin}(0)$) in the reference specimen,

$$N'_{spin}(N)/N'_{spin}(0) = A'\log_{10}(N+1) + 1 \dots (2)$$

where, in Equation (2), $N'_{spin}(N)$ is the number of spins in the reference specimen after the load is applied N times, $N'_{spin}(0)$ is the number of spins in the reference specimen before the load is applied, and A' is a constant.

12. The deterioration evaluation method according to claim 11, wherein
the evaluation step includes an estimation step of substituting the number of spins detected in the detection step into $N'_{spin}(N)$ in Equation (2) and estimating the number of times the load is applied to the measurement target.

13. The deterioration evaluation method according to claim 12, wherein

the preparation step includes a step of finding the number of applications of the load at which damage of the reference specimen occurs, and
the evaluation step includes a step of finding a remaining service life of the measurement target by subtracting the number of times the load is applied to the measurement target estimated in the estimation step from the number of applications of the load at which damage of the reference specimen occurs.

14. The deterioration evaluation method according to claim 8, wherein
the measurement target is a carbon fiber composite material.

FIG. 1

EP 4 394 367 A1

# FIG. 2

# FIG. 3

PREPARE REFERENCE SPECIMEN — S11

MEASURE REFERENCE SPECIMEN — S12

APPLY LOAD — S13

MEASURE SERVICE LIFE — S14

CALCULATE CRITICAL VALUE — S15

S1

MEASURE MEASUREMENT TARGET — S21

APPLY LOAD — S22

S2

GRAPHING — S31

FITTING — S32

ESTIMATE SERVICE LIFE — S33

S3

# FIG. 4

S1'
- PREPARE REFERENCE SPECIMEN — S11
- MEASURE REFERENCE SPECIMEN — S12
- GRAPHING — S17
- FITTING — S18

S16 (S17, S18)

APPLY LOAD — S13

MEASURE SERVICE LIFE — S14

S2'
- MEASURE MEASUREMENT TARGET

S3'
- ESTIMATE NUMBER OF LOAD APPLICATIONS — S34
- ESTIMATE SERVICE LIFE — S35

# FIG. 5

# FIG. 6

# FIG. 7

# FIG. 8

# FIG. 9

# FIG. 10

# FIG. 11

# FIG. 12

## FIG. 13

S= 0.25

S= 0.5

$N_{spin}$ ($10^{19}$/g)

Number of loads

## FIG. 14

S= 0.25

S= 0.5

$N_{spin}$ ($10^{19}$/g)

Number of loads

## INTERNATIONAL SEARCH REPORT

| International application No. |
|---|
| **PCT/JP2022/043495** |

**A. CLASSIFICATION OF SUBJECT MATTER**

*G01N 24/10*(2006.01)i

FI: G01N24/10 510L; G01N24/10 510R

According to International Patent Classification (IPC) or to both national classification and IPC

**B. FIELDS SEARCHED**

Minimum documentation searched (classification system followed by classification symbols)

G01N24/00-G01N24/14, G01R33/00-G01R33/64, A61B5/05, G01N22/00-G01N22/04, G01B15/00-G01B15/08

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

JSTPlus/JMEDPlus/JST7580 (JDreamIII), JSTChina (JDreamIII)

**C. DOCUMENTS CONSIDERED TO BE RELEVANT**

| Category* | Citation of document, with indication, where appropriate, of the relevant passages | Relevant to claim No. |
|---|---|---|
| X | WO 2009/039241 A1 (THE REGENTS OF THE UNIVERSITY OF CALIFORNIA) 05 March 2009 (2009-03-05) | 1-7 |
| | paragraphs [0019]-[0022], [0034]-[0037], [0041]-[0056], [0111]-[0140], fig. 1-4, 16-19 | |
| Y | | 1-7 |
| X | EPR INSTRUMENTS. Magnettech ESR5000. PRODUCTS & SOLUTIONS [online]. BRUKER. 25 October 2021, <URL: https://webarchive.org/web/20211025010759/https://www.bruker.com/en/products-and-solutions/mr/epr-instruments/magnettechesr5000.html> "Highlights", "Applications", "Specifications" | 8-9, 14 |
| Y | | 1-7, 10-13 |

☑ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **16 December 2022** | **10 January 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**

| | International application No. |
|---|---|
| | **PCT/JP2022/043495** |

## C. DOCUMENTS CONSIDERED TO BE RELEVANT

| Category* | Citation of document, with indication, where appropriate, of the relevant passages | Relevant to claim No. |
|---|---|---|
| Y | 電子スピン共鳴(ESR)・電子スピン共鳴イメージング(ESRI)の動向と基礎・応用科学分野及び学際分野での応用, 九州大学中央分析センターニュース, 30 July 2007, vol. 26, no. 3, pp. 1-6<br>"5. Innovative development of ESR measurement from an resonator-type ESR to an electromagnetic horn-type ESR~ESR measurement~", non-official translation (Trends in electron spin resonance (ESR) and electron spin resonance imaging (ESRI) and their applications to basic and applied science fields and interdisciplinary fields. Center of Advanced Instrumental Analysis, Kyushu University News.) | 1-7 |
| X | 技術紹介　ブルカージャパン株式会社　電子スピン共鳴法の基礎と応用例, ぶんせき, July 2021, July issue, pp. 337-345<br>"6. Application examples of ESR", non-official translation (Technology Introduction of BRUKER JAPAN KK: Basics and Application Examples of Electron Spin Resonance Method. BUNSEKI.) | 8-9, 14 |
| Y | | 10-13 |
| Y | SPINCOUNT. PRODUCTS & SOLUTIONS [online]. BRUKER. May 2021<br>"Quantification" | 10-13 |
| Y | Pharmaceutical Applications of EPR. PRODUCTS & SOLUTIONS [online]. BRUKER. August 2021<br>"Degradation correlates with the EPR signal" | 10-13 |

Form PCT/ISA/210 (second sheet) (January 2015)

<table>
<tr><td align="center">**INTERNATIONAL SEARCH REPORT**</td><td>International application No.<br><br>**PCT/JP2022/043495**</td></tr>
</table>

| **Box No. III**      **Observations where unity of invention is lacking (Continuation of item 3 of first sheet)** |
| --- |

This International Searching Authority found multiple inventions in this international application, as follows:

The present application is classified into the following two inventions.

(Invention 1) Claims 1-7
    An electron spin resonance apparatus having a configuration in which frequencies of microwaves emitted from an opening of a cavity resonator to an object to be measured and intensities of a magnetic field applied toward an emitting surface of the microwaves emitted to the object to be measured are modulated by a modulation coil.

(Invention 2) Claims 8-14
    A method of using an electron spin resonance signal to evaluate degradation of an object to be measured, wherein the electron spin resonance signal is detected by emitting microwaves to the object to be measured and applying a magnetic field to an emitting surface of the microwaves.

1. ☐ As all required additional search fees were timely paid by the applicant, this international search report covers all searchable claims.

2. ☑ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**    ☐ The additional search fees were accompanied by the applicant's protest and, where applicable, the payment of a protest fee.

                            ☐ The additional search fees were accompanied by the applicant's protest but the applicable protest fee was not paid within the time limit specified in the invitation.

                            ☐ No protest accompanied the payment of additional search fees.

Form PCT/ISA/210 (continuation of first sheet) (January 2015)

**INTERNATIONAL SEARCH REPORT**
Information on patent family members

International application No.

**PCT/JP2022/043495**

| Patent document cited in search report | Publication date (day/month/year) | Patent family member(s) | Publication date (day/month/year) |
|---|---|---|---|
| WO 2009/039241 A1 | 05 March 2009 | US 2011/0150779 A1<br>US 2009/0121712 A1 | |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022001004 A
- JP 5481651 B
- JP 2015049072 A